# EUROPEAN PATENT APPLICATION

(11) **EP 0 932 205 A1**
(43) Date of publication of application: **28.07.1999**
(21) Application number: 98309005.1
(22) Date of filing: 02.11.1998
(51) Int. Cl.: H01L 29/36, H01L 29/861, H01L 21/329

(54) **PN junction semiconductor device having an epitaxial layer with graded resistivity**

(30) Priority: 21.01.1998 US 10471
(71) Applicant: GENERAL SEMICONDUCTOR, Inc., Melville, NY 11747-3113 (US)
(72) Inventor: Chan, Joseph Y., Kings Park, New York 11754 (US); Amato, John E., Northport, New York 11768 (US); Eng, Jack, Bellmore, New York 11710 (US); Einthoven, Willem G., Belle Meade, New Jersey 08502 (US); Tan, Shiang Y., Farmingdale, New York 11735 (US); Zakaluk, Gregory J., North Seaford, New York 11783 (US); LaTerza, Lawrence E., Miller Place, New York 11764 (US); Garbis, Dennis, South Huntington, New York 11746 (US)
(74) Representative: Bluff, John William

(57) **Abstract**

A semiconductor device, for instance a fast switching rectifier, which includes an epitaxially grown region on a substrate. At least one PN junction in the epitaxial region has an improved ability to withstand transient signals such as electrostatic discharges of significant magnitude by having a portion of the epitaxially grown layer between the substrate and the PN junction having a graded resistivity, the resistivity increasing towards the PN junction, preferably varying exponentially with thickness. In one embodiment for N type substrate the gradation is from about 0.005 ohm-centimetres to about 7-12 ohm-centimetres over a thickness of about 15 micrometres, this being accomplished by varying the amount of impurity during epitaxial growth.

## Description

This invention relates to a semiconductor device having an epitaxially grown region and a method of forming such a device. The invention finds particular application to devices in which a PN junction is formed in the epitaxially grown region. Such a semiconductor structure may be used in fast switching rectifiers.

The invention is concerned with improving the ability of semiconductor devices with epitaxially grown regions to withstand transient signals of significant magnitude. It is particularly well adapted for use in connection with fast switching diodes, and especially those designed to carry significant amounts of current, as in the 1-3 ampere range.

Semiconductor devices are designed for use in circuits which normally carry predetermined amounts of current and are subject to signals normally within a given voltage range. The art has learned to design semiconductors for particular current and voltage requirements. However, a problem often presents itself. Transient signals such as electrostatic discharge pulses having a voltage magnitude significantly exceeding the normal expected range sometimes occur, and the ability of the semiconductor devices to accept such excessive signals without permanent damage is important. Obviously devices which can withstand such excessive voltage pulses are greatly to be preferred over devices which cannot do so. One major source of such excessive transient voltage signals is the occurrence of electrostatic discharge in the circuit, and this invention will be here specifically described by specific reference to such electrostatic discharge pulses, although it will be understood that insofar as this invention is concerned other types of voltage pulses may be dealt with. The problem is particularly, but not exclusively, presented in connection with semiconductor rectifiers, and particularly such rectifiers where fast switching is important, and the invention will be specifically described in connection with such a device, but it will be understood that the utility of the invention is not limited to such a device.

In forming such devices it is necessary to control the resistivity of different areas of thickness of the device, and this is generally accomplished by controlling the impurity-content of any given area or thickness. Diffusion and epitaxial growth are two processes generally used to that end. When diffusion is employed the full thickness of the device at a given point in its manufacture is subjected to an atmosphere which includes a resistance-varying impurity under conditions such that atoms of that impurity enter the semiconductor body through its exposed surface and travel into that body to a predetermined depth. With epitaxial growth, a substrate is exposed to a given atmosphere under given conditions so that semiconductor material actually grows onto the substrate to its full thickness, and the resistivity of the epitaxially grown layer depends upon the amount of impurity present in the atmosphere to which the substrate is exposed during epitaxial growth. The resistivity of the substrate is of course different from that of the epitaxially grown layer, and there is, between the substrate and the epitaxial layer of desired resistivity, a region of change of resistivity, generally referred to as the interface, where the rate of change of resistivity with thickness is very great.

Devices such as semiconductor diodes made from epitaxial wafers are nearly always superior to devices made by an all-diffusion process with respect to most operating characteristics. In such devices a layer of given thickness is epitaxially grown on a substrate in the presence of a concentration of dopants sufficient to give the grown epi-thickness the proper resistivity, and a PN junction is subsequently formed in that layer. The use of epitaxial growth rather than diffusion to produce a layer of the proper resistivity can be more advantageous, due to the fact that epitaxial layers can be formed with successive higher or lower doping at will, while diffused layers must have a higher doping than the layer in which they are diffused. However, epitaxially=formed rectifiers of that type have one significant drawback when compared with deep diffusion-formed rectifiers -- they are considerably less resistant to transient voltages. Such epitaxially formed rectifiers, heretofore manufactured by the present applicant, have experienced difficulty in withstanding transient pulses of more than 5000 volts without permanent failure, but rectifiers formed using deep diffusion to control resistivity can withstand much higher transient signals without damage.

We have discovered how to make semiconductor devices such as fast switching diodes of the epitaxial type which have the advantageous mechanical and electrical characteristics normally associated with such devices but which exhibit a greater, improved resistance to transient signals when compared to prior art epitaxial devices. For example, epitaxial devices which in the past have had difficulty in withstanding 5000 volt transient signals can, when made in accordance with the present invention, readily withstand transient signals as high as 25,000 volts. These transients are pulses of a very short duration, microseconds or picoseconds, and with limited energy. Because the current of these very short pulses is difficult to measure, they are normally defined, for a particular circuit, by their starting voltage, which may normally be in the range of 2000-25,000 volts.

This surprising result may be accomplished by modifying the semiconductor material as it is being epitaxially grown on the substrate so that different layers of the epitaxially grown material, over a given thickness less than the total thickness of the grown layer, will relatively gradually vary in resistivity, slowly changing in resistivity as the individual layers are more remote from the substrate, until the resistivity reaches its desired end value, subsequently continuing to epitaxially form layers with a resistivity of that desired end value, and thereafter forming the device's PN junction in that subsequently grown thickness. This results in the formation of an interface region -- which we call the graded interface -- which is significantly greater in thickness than the interface in prior art epitaxial devices, and since the resistivity difference between substrate and PN junction area is essentially the same as in prior art devices the rate of change of resistivity with thickness in the graded interface area is much less than has been the case in prior art devices. For example in the interface area of prior art devices the resistivity might change by more than three orders of magnitude in 10 microns of thickness, whereas in the graded interface now proposed it may change only one order of magnitude in the same 10 microns, the thickness of the interface being increased approximately three-fold to accommodate the needed resistivity change. The optional extent of the thickness of that graded interface may vary from one type of device to another but can readily be empirically determined for any given device. By thus providing a graded interface between the original substrate and that portion of the epitaxially grown layer in which the PN junction is formed, the resistance to damage from transient signals is greatly increased.

It is significant that this improvement is achieved using essentially the normal epitaxial growth process and apparatus, so no appreciable increase in manufacturing time and expense is involved. In the past the epitaxial layer has been grown while supplying dopant in a constant concentration such as to produce the desired resistivity in the epitaxially grown layer. In order to produce the improved devices of the present invention, all that need be done with the normal process is to vary the amount of dopant provided as the epitaxial layer is being grown during the time that the epitaxial growth is producing the graded interface and then, when the layer resistivity has reached the desired final value, continuing the epitaxial growth with a constant impurity concentration as has been normal.

The preferred practice of the present invention enables the following objects to be achieved:
to provide epitaxially grown semiconductor devices as semiconductor diodes with improved resistance to transient signals; and
to provide a method for forming semiconductor devices such as diodes which, when formed, will have the usual advantages of epitaxially produced devices but with the additional advantage of improved resistance to transient signals such as electrostatic discharge.

Aspects of the present invention are set forth in the appended claims. The present invention and its preferred practice to produce epitaxial-type semiconductors with improved resistance to transient signals will now be described with reference to the accompanying drawings in which:
Fig. 1 is a cross-sectional view of one type of semiconductor device in connection with which the instant invention is useful, that being a commercial glass passivated semiconductor junction rectifier;
Fig. 2 is a representative graph on semi-log paper of the relationship between resistivity in a given layer of a typical prior art epitaxial body grown on a substrate, resistivity being expressed in ohm-centimeters on the log-scale ordinate and distance being expressed in microns on the normal-scale abscissa, Fig. 2 representing the situation after normal epitaxial growth with constant impurity concentration;
Fig. 3 is a graph similar to Fig. 2 but showing the resistivity-distance relationship after a PN junction has been formed in the device of Fig. 2;
Fig. 4 is a view similar to Fig. 2 but showing the resistivity-distance relationship when the process of the present invention has been carried out; and
Fig. 5 is a view similar to Fig. 3, showing the resistivity-distance relationship for the device of Fig. 4 after the PN junction has been formed therein.

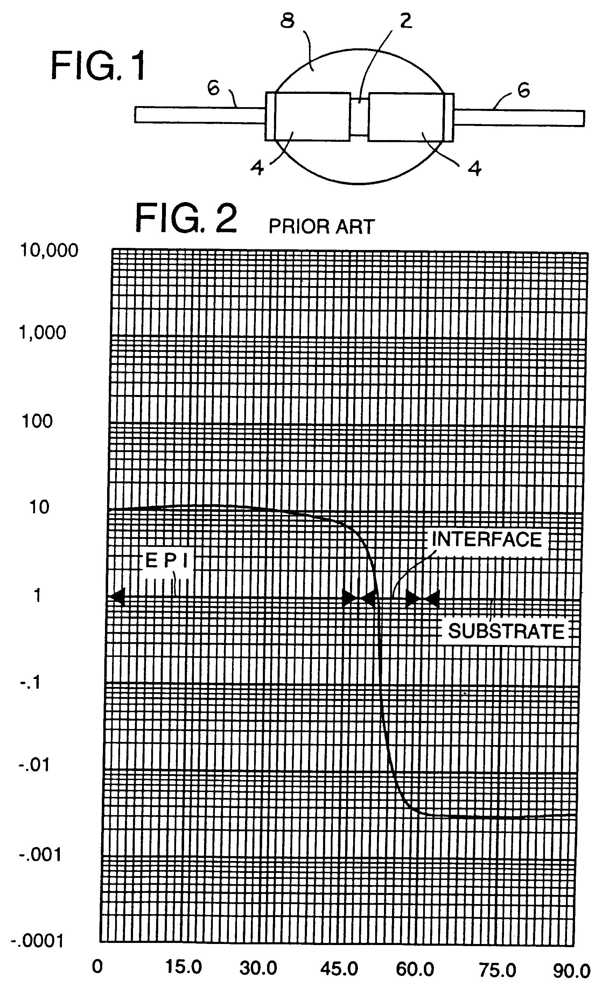

In Figs. 2-5 the total thickness of the silicon, which may be over 300 microns, is not shown; only approximately 90 microns of its thickness is shown. The portion thereof not shown is substrate, with a constant resistivity.

The graphs, Figs. 2-5, are representative of devices that have been made and tested by applicant, but the corresponding graphs of different devices of the same character may well vary somewhat one from the other, and hence the graphs are representative only.

The glass passivated rectifier shown in Fig. 1 is one commercial type of semiconductor device with respect to which the instant invention is advantageous. It comprises a silicon die 2 in which a PN junction is formed so that the device will function as a rectifier. Molybdenum slugs 4 are aluminum-brazed to opposite faces of the die 2, copper leads 6 are brazed to the slugs 4, and an extremely pure specially developed glass 8 is applied in direct contact with the silicon junction, creating an ideal cavity-free passivating medium. The present invention relates to the way in which the silicon die 2 is fabricated so that it will function as a rectifier and exhibit considerably improved resistance to large transient signals.

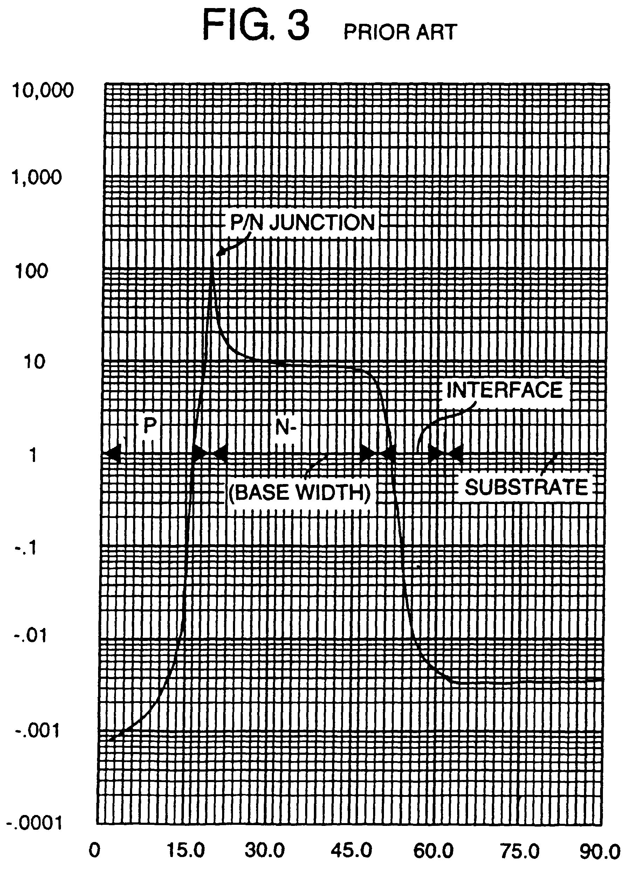

A conventional way for forming the silicon die 2 is to start with an N type silicon substrate of predetermined minimal resistivity, such as something less than 0.005 ohm-centimeters, and epitaxially growing thereon to a predetermined thickness an N type layer of considerably greater resistivity, and then introducing into the outer portion of that epitaxially grown layer P type impurities so as to form a PN junction. The apparatus and operating conditions for such operations are conventional and well known in the industry. Fig. 2 is a graph of the relation between the resistivity over a cross-section of the epitaxially grown layer and the substrate. The distance in Fig. 2 is measured from the surface of the epitaxially grown region. Hence the epi-layer is on the left, the substrate on the right. The resistivity of the original substrate is shown as approximately 0.0035 ohm-centimeters and the resistivity of the epitaxially grown region is shown as approximately 10 ohm-centimeters, a difference of more than three orders of magnitude. As is well known, the resistivity of the epitaxially grown region is determined by the presence in the reactor chamber where the epitaxial growth takes place of an appropriate dopant such as phosphine gas, usually provided in a hydrogen carrier at a concentration of 15 parts of phosphine gas per million parts of the hydrogen carrier, and the amount of impurity which will be present in each layer of the epitaxially grown region will depend upon how much of that hydrogen-phosphine gas combination is present in the reaction chamber. Typically, providing 125 cc. per minute of the phosphine-hydrogen combination will produce an epitaxially grown region having a resistivity of about 10 ohm-centimeters. The transition between the substrate resistivity and the epitaxially grown resistivity is not truly abrupt, but is quite rapid, as represented by the steep portion of the graph of Fig. 2, that transition in resistivity taking place over a thickness of approximately 10 microns, thus producing a resistivity change of more than three orders of magnitude over the interface thickness of approximately 10 microns. After the epitaxially grown region has attained the desired thickness, here shown as approximately 50 microns, the epitaxial growth is terminated and a PN junction is then formed in the device at approximately 20 microns from its upper surface, with the resistivity-distance results shown in Fig. 3. The manner of formation of the PN junction is conventional. From the point of view of the present invention it is important to bear in mind that the reaction conditions during the entire time that the epitaxially grown layer is being formed are maintained substantially constant.

Rectifiers manufactured in this manner function excellently, with one major exception. When they are subjected to substantially instantaneous signals of high voltage, such as over 5000 volts, they tend to permanently malfunction. Competitive rectifiers made by using diffusion rather than epitaxial growth are better able to withstand such transient voltages, but in general they are more difficult and often more costly to manufacture to a difficult specification of electrical parameters than rectifiers using epitaxial growth and their other operating characteristics usually leave something to be desired when compared to those of epitaxially formed rectifiers.

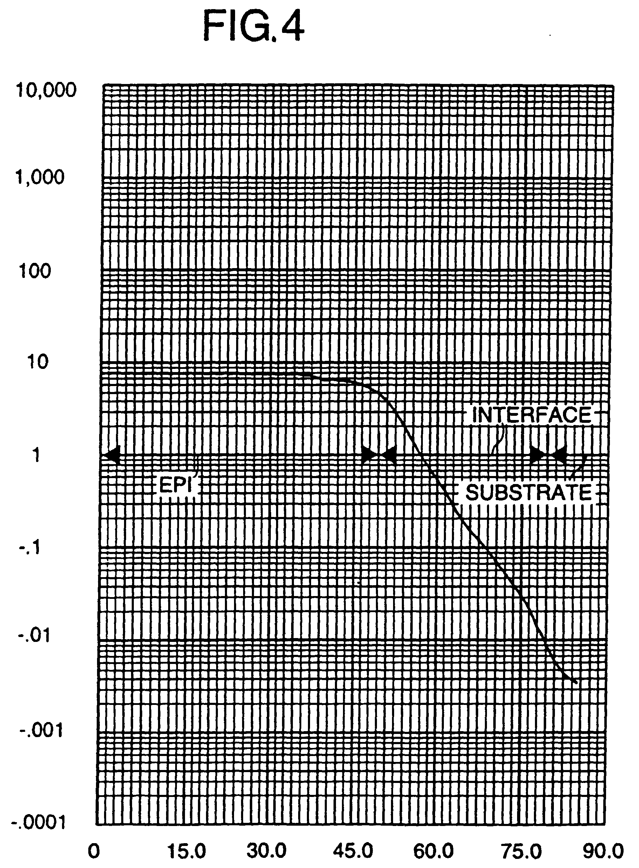

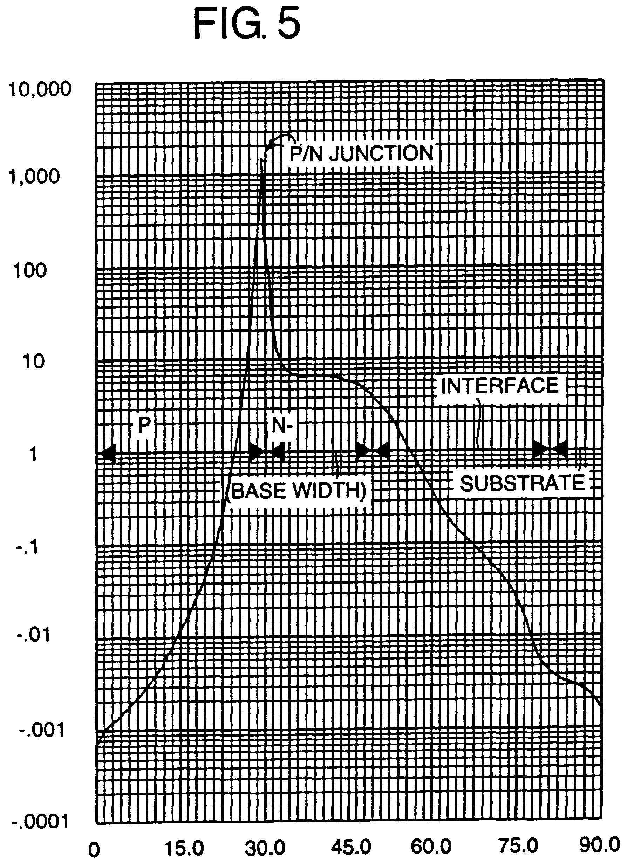

We have found that if the resistivity transition between the substrate and the epitaxial region is made to be much more gradual than has heretofore been the case, as representatively shown in Figs. 4 and 5, a very much greater resistance to high instantaneous voltages is exhibited. Thus while, as has been pointed out, in prior art epitaxial rectifier manufacture a resistivity change of about three orders of magnitude occurs over a thickness of about 10 microns, if that same three orders of magnitude variation in resistivity is caused to occur over a considerably greater thickness, the desired increased resistance to high voltage signals is achieved. This is illustrated in Figs. 4 and 5, which correspond to Figs. 2 and 3 except showing the utilization of the present invention. Comparing Figs. 4 and 5 with Figs. 2 and 3 it will be seen that the slope of the rising portion of the graphs of Figs. 4 and 5 is considerably less than the slope of the rising portion of the graphs of Figs. 2 and 3. That is because the transition between substrate resistivity of 0.0035 ohm-centimeters and the epitaxial region resistivity of 10 ohm-centimeters takes place over a thickness of 20-25 microns rather than 10 microns. It is preferred that the rate of change of resistivity relative to thickness in the graded interface region is not appreciably greater than a tenfold variation in resistivity per 10 microns of thickness.

As illustrated, the resistivity-thickness line in the graded interface region of Fig. 5 is substantially linear on the log-scale, indicating that the resistivity is varied substantially exponentially with thickness in that region, and such variation is generally preferred, but it is not essential to achieve the indicated desired result. The resistivity for the substrate and for the epitaxial region may vary from device to device depending upon the particular device requirements. The thickness of the graded interface area is likewise subject to variation, although we have found that if the thickness of the interface area is too great -- perhaps as great as 40 microns -- other operating characteristics of the device may be adversely affected.

To produce semiconductor devices with the characteristics of the present invention is a surprisingly simple matter. Essentially the only alteration that is required to the well established prior art epitaxial growth process which produces devices with the characteristics illustrated in Figs 2 and 3, in which the dopant such as the phosphine-hydrogen combination is present in constant concentration during the time of epitaxial growth, is to vary that concentration from the beginning of epitaxial growth for a period of time corresponding to the growth of a graded interface region of desired thickness, thereafter maintaining the dopant concentration at a constant value during the growth of the remainder of the epitaxial layer. Thus instead of using a constant impurity application of 15 parts per million of phosphine in hydrogen at a rate of 125 cc. per minute, one can start with 2000 parts per million of phosphine in hydrogen at a rate of 100 cc. per minute and ramp the amount of impurities down to a final setting of 30 cc. per minute over the period of time necessary to grow the approximately 25 microns of graded interface. Thereafter, to grow the remainder of the epitaxial region, one can use the conventional concentration of 15 parts per million of phosphine in hydrogen at a rate of 125 cc. per minute.

The total thickness of the epitaxial layer for devices of the specific type here under discussion may be between 76 and 84 microns, the graded interface thickness should be more than 15 microns, may be 20-30 microns, 25 microns ± 10% is desirable, and not more than 40 microns, and its resistivity may be 7-12 ohm-centimeters. These figures are appropriate where one wants the substrate resistivity to be less than 0.005 ohm-centimeters and the final resistivity of the epitaxial layer to be about 7-12 ohm-centimeters.

We have tested rectifiers of the prior art epitaxial type and corresponding rectifiers made according to the present invention by subjecting them to a 25,000 volt pulse applied to the rectifier in reverse bias mode. Rectifiers fabricated with standard epitaxial growth are destroyed by such pulses but rectifiers made according to the present invention do not fail. While we are not sure why this unexpected result is achieved, we believe it is because, with the graded interface region, the depletion region of the diode at breakdown will reach that graded interface region and the graded interface region will, because of its resistivity-distance profile, be able to withstand the pulse.

The present invention has been described specifically with respect to an N type device in which a P type region is formed to produce the PN junction, but the invention is also applicable to initially P type devices into which an N type region is formed. More than one PN junction may be formed.

While but a limited number of specific embodiments of the present invention have been here described, it will be apparent that the invention is of more general applicability, as defined in the following claims.

## Claims

1. The method of improving the resistance to electrostatic discharge of a PN junction formed in a semiconductor device having a substrate with an epitaxially grown body thereon which comprises growing an epitaxial body on said substrate while, over a given thickness of said body extending away from said substrate, causing the resistivity of layers of the epitaxially grown body to vary in a given sense as those layers are increasingly spaced from said substrate to produce an interface portion of said given thickness, and forming a PN junction in said epitaxial body on the other side of said interface portion from said substrate.

2. The method of claim 1, in which said resistivity in said interface portion increases in layers thereof increasingly remote from said substrate.

3. The method of claim 2, in which said given thickness is more than about 15 microns.

4. The method of claim 2, in which said given thickness is about 20-30 microns.

5. The method of claim 2, in which said given thickness is about 15-40 microns

6. The method of claim 5, in which over said given thickness the resistivity of layers of said interface portion varies substantially linearly with respect to distance from said substrate.

7. The method of claim 5, in which over said given thickness the resistivity of layers of said interface portion varies with respect to distance from said substrate from about 0.005 ohm-centimeters to about 7-12 ohm-centimeters.

8. The method of claim 5, in which over said given thickness the resistivity of layers of said interface portion varies with respect to distance from said substrate substantially linearly from about 0.005 ohm-centimeters to about 7-12 ohm-centimeters.

9. The method of claim 5, in which the thickness of said epitaxially grown body is greater than said given thickness and said PN junction is formed in a portion of said body spaced beyond said given thickness.

10. The method of claim 5, in which the thickness of said epitaxially grown body is greater than said given thickness and said PN junction is formed in a portion of said body spaced beyond said given thickness, said portion having a resistivity equal to or higher than the maximum value of the resistivity of said interface portion.

11. The method of claim 5, in which over said given thickness the rate of change of resistivity relative to thickness is not appreciably greater than a tenfold variation in resistivity per 10 microns of thickness.

12. The method of claim 11, in which the resistivity of layers of said interface portion varies substantially linearly with respect to distance from said substrate.

13. The method of claim 11, in which the resistivity of layers of said interface portion varies from about 0.005 ohm-centimeters to about 7-12 ohm-centimeters with respect to distance from said substrate.

14. The method of claim 11, in which the resistivity of layers of said interface portion varies substantially linearly from about 0.005 ohm-centimeters to about 7-12 ohm-centimeters with respect to distance from said substrate.

15. The method of claim 5, in which said device comprises a diode.

16. The method of improving the resistance to electrostatic discharge of a PN junction formed in a semiconductor device having a substrate with an epitaxially grown body thereon which comprises growing an epitaxial body on said substrate while, over a given thickness of said body extending away from said substrate, causing the resistivity of layers of the epitaxially grown body to increase from about 0.005 ohm-centimeters to about 7-12 ohm centimeters substantially linearly with respect to distance from said substrate as those layers are increasingly spaced from said substrate to produce an interface portion of said given thickness, and forming a PN junction in said epitaxial body on the other side of said interface portion from said substrate, said given thickness being about 15-40 microns, said epitaxially grown body being grown to a thickness which is greater than said given thickness and said PN junction being formed in a portion of said body spaced beyond said given thickness, the rate of change of resistivity relative to thickness over said given thickness being not appreciably greater than a tenfold variation in resistivity per 10 microns of thickness.

17. A semiconductor device which exhibits improved resistance to electrostatic discharge, the device comprising a substrate with an epitaxially grown body thereon and with an interface region in said epitaxially grown body between said substrate and the remainder of said epitaxially grown body and having a PN junction in said remainder of said epitaxially grown body, said interface region having a thickness of more than about 15 microns and the layers of said interface region varying in resistivity outwardly from said substrate.

18. The semiconductor device of claim 17, in which said interface region has a thickness of about 20-30 microns.

19. The semiconductor device of claim 17, in which said interface region has a thickness of about 15-40 microns.

20. The device of claim 17, in which the layers of said interface region increase in resistivity from said substrate outwardly.

21. The device of claim 17, in which the layers of said interface region increase in resistivity from said substrate outwardly from about 0.005 ohm-centimeters to about 7-12 ohm-centimeters.

22. The device of claim 17, in which said resistivity in the layers of said interface region increases substantially linearly with respect to distance from said substrate.

23. A semiconductor device which exhibits improved resistance to electrostatic discharge, the device comprising a substrate with an epitaxially grown body thereon and with an interface region in said epitaxially grown body between said substrate and the remainder of said epitaxially grown body and having a PN junction in said remainder of said epitaxially grown body, said interface region having a thickness of about 15-40 microns, the resistivity of the layers of said interface region increasing from about 0.005 ohm-centimeters to about 7-12 ohm-centimeters substantially linearly with respect to distance from said substrate, the rate of change of resistivity relative to thickness over said interface region being not appreciably greater than a tenfold variation in resistivity per 10 microns of thickness.
